# EUROPEAN PATENT APPLICATION

(11) **EP 4 598 306 A1**
(43) Date of publication of application: **06.08.2025**
(21) Application number: 25154648.7
(22) Date of filing: 29.01.2025
(51) Int. Cl.: H10D 84/01, H10D 30/00, H10D 30/67, H10D 84/85, H10D 88/00, H10D 84/83, H10D 62/10, H10D 64/01

(54) **SEMICONDUCTOR DEVICE INCLUDING STACKED FORKSHEET TRANSISTOR STRUCTURE WITH ISOLATION WALL**

(30) Priority: 05.02.2024 US 202463549732 P; 24.05.2024 US 202418674073
(71) Applicant: Samsung Electronics Co., Ltd., Suwon-si, Gyeonggi-do 16677 (KR)
(72) Inventor: PARK, Panjae, San Jose, CA 95134 (US); YUN, Seungchan, San Jose, CA 95134 (US); YANG, Myung, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Provided is a semiconductor device comprising a 1^{st} source/drain pattern; a 1^{st} active contact on the 1^{st} source/drain pattern; and an isolation wall contacting the 1^{st} active contact. Provided is also semiconductor device which includes: a 1^{st} source/drain pattern; a 2^{nd} source/drain pattern; an isolation wall between the 1^{st} source/drain pattern and the 2^{nd} source/drain pattern; a 1^{st} active contact on the 1^{st} source/drain pattern; and a 2^{nd} active contact on the 2^{nd} source/drain pattern, wherein the 1^{st} active contact contacts a 1^{st} side surface of the isolation wall, and the 2^{nd} active contact contacts a 2^{nd} side surface of the isolation wall, opposite to the 1^{st} sidewall.

## Description

### BACKGROUND

### 1. Field

Apparatuses and methods consistent with the disclosure relate to a semiconductor device of a forksheet transistor structure including an isolation wall.

### 2. Description of Related Art

The nanosheet transistor was introduced to address shortcomings of the Fin field-effect transistor (FinFET). The FinFET has one or more horizontally arranged vertical fin structures as a channel structure, in which three surfaces of each fin structure are surrounded by a gate structure, and the nanosheet transistor is characterized by one or more nanosheet layers vertically stacked on a substrate as a channel structure and a gate structure surrounding all four surfaces of each of the nanosheet layers. The nanosheet transistor is known to allow a better control of current and enable a higher device density than the FinFET in forming a semiconductor device. The nanosheet transistor is also referred to as gate-all-around (GAA) transistor, or as a multi-bridge channel field-effect transistor (MBCFET)

Recently, the nanosheet transistor has evolved into a forksheet transistor which enables further miniaturization of a semiconductor device. The forksheet transistor may take a form of a combination of two nanosheet transistors with an isolation wall therebetween as an insulation backbone. Nanosheet channel layers of each nanosheet transistor in the forksheet transistor may be formed at each side of the isolation wall and pass through a gate structure of the nanosheet transistor at each side of the isolation wall.

The present disclosure provides a semiconductor device based on a forksheet transistor structure which achieves an additional area gain and enables an improved manufacturing process.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

According to an aspect of example embodiments, there is provided a semiconductor device which may include: a 1^{st} source/drain pattern; a 2^{nd} source/drain pattern; an isolation wall between the 1^{st} source/drain pattern and the 2^{nd} source/drain pattern; a 1^{st} active contact on the 1^{st} source/drain pattern; and a 2^{nd} active contact on the 2^{nd} source/drain pattern, wherein the 1^{st} active contact contacts a 1^{st} side surface of the isolation wall, and the 2^{nd} active contact contacts a 2^{nd} side surface of the isolation wall, opposite to the 1^{st} sidewall.

According to an aspect of example embodiments, there is provided a semiconductor device which may include: a 1^{st} source/drain pattern; a 1^{st} active contact on the 1^{st} source/drain pattern; and an isolation wall contacting the 1^{st} active contact.

According to an aspect of example embodiments, there is provided a method of manufacturing a semiconductor device, which may include: forming a channel structure on a substrate; forming a recess penetrating through the channel structure to divide the channel structure into a 1^{st} channel structure and a 2^{nd} channel structure; forming an isolation wall in the recess; forming a 1^{st} source/drain pattern on the 1^{st} channel structure; and forming a 1^{st} active contact contacting the isolation wall and the 1^{st} source/drain pattern.

### BRIEF DESCRIPTION OF DRAWINGS

Example embodiments of the disclosure will be more clearly understood from the following detailed description taken in conjunction with the accompanying drawings.
FIGS. 1A-1C illustrate a 3D-stacked semiconductor device including forksheet transistors with active contacts thereon, according to one or more embodiments.
FIG. 2 illustrates a 3D-stacked semiconductor device including forksheet transistors with active contacts thereon, according to one or more other embodiments.
FIG. 3 illustrates a 3D-stacked semiconductor device including forksheet transistors with active contacts thereon, according to one or more other embodiments.
FIGS. 4 and 5 illustrate 3D-stacked semiconductor devices including forksheet transistors with active contacts contacting an isolation wall, according to one or more other embodiments.
FIGS. 6A through 6L illustrate cross-section views of intermediate 3D-stacked semiconductor devices after respective steps of manufacturing a 3D-stacked semiconductor device including forksheet transistors with active contacts contacting an isolation wall, according to one or more embodiments.
FIGS. 7A and 7B illustrate a flowchart of a method of manufacturing a 3D-stacked semiconductor device including forksheet transistors with active contacts contacting an isolation wall, according to one or more embodiments.
FIG. 8 is a schematic block diagram illustrating an electronic device including a semiconductor device in which contact structures having different contact areas are formed on respective source/drain regions, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed in the description of an embodiment could be termed a 2^{nd} element in a claim without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor or a forksheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

Herebelow, various embodiments provide an improved structure of a semiconductor device including a plurality of forksheet transistors.

A 3D-stacked semiconductor device has been introduced in response to increased demand for a semiconductor device having a higher device density and performance. The 3D-stacked semiconductor device may include a 1^{st} transistor at a 1^{st} level and a 2^{nd} transistor at a 2^{nd} level above the 1^{st} level. The present disclosure provides a 3D-stacked semiconductor device which each of the transistors at the 1^{st} level and the 2^{nd} level is formed by a forksheet transistor.

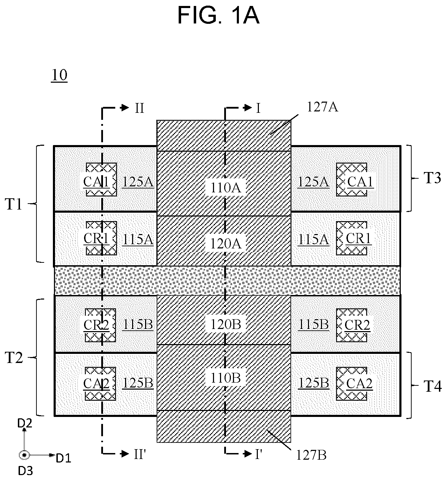

FIGS. 1A-1C illustrate a 3D-stacked semiconductor device including forksheet transistors with active contacts thereon, according to one or more embodiments.

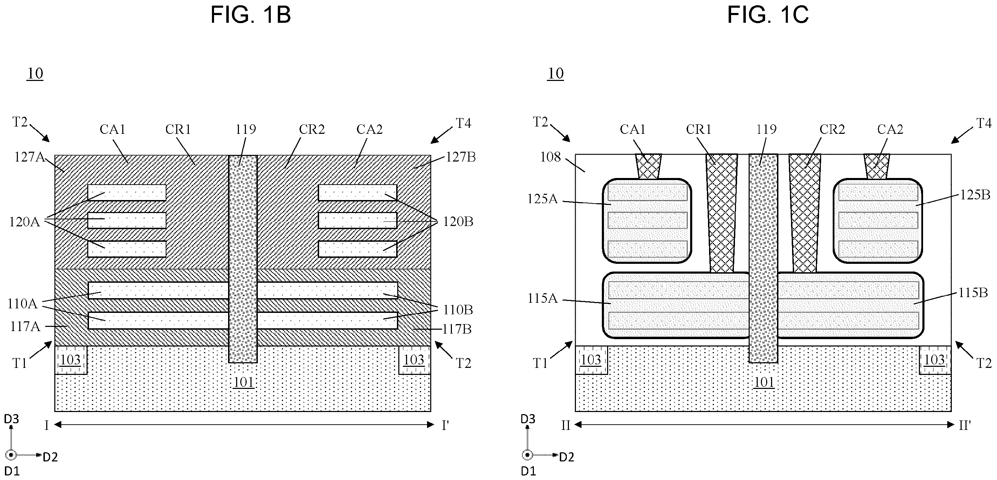

FIG. 1A is a plan view of a 3D-stacked semiconductor device 10, FIG. 1B is a cross-section view of the 3D-stacked semiconductor device 10 shown in FIG. 1A taken along lines I-I', and FIG. 1C is a cross-section view of the 3D-stacked semiconductor device 10 shown in FIG. 1A taken along lines II-II'. It is to be understood here that FIG. 1A is provided to show a positional relationship between selected structural elements of the 3D-stacked semiconductor device 10, and thus, some structural elements including a substrate are not shown in FIG. 1A.

As shown in FIGS. 1A-1C, a D1 direction is a channel-length direction in which a current flows between two source/drain patterns (or source/drain regions) connected to each other through a channel structure, a D2 direction is a channel-width direction that intersects the D1 direction, and a D3 direction is a vertical direction that intersects the D1 and D2 directions both of which are horizontal directions.

Referring to FIGS. 1A-1C, the 3D-stacked semiconductor device 10 may include a plurality of nanosheet transistors. For example, the 3D-stacked semiconductor device 10 may be formed of 1^{st} to 4^{th} nanosheet transistors T1-T4. In the 3D-stacked semiconductor device, the 1^{st} nanosheet transistor T1 and the 2^{nd} nanosheet transistor T2 may be formed at a 1^{st} level on a substrate 101, and isolated from each other by an isolation wall 119. Further, the 3^{rd} nanosheet transistor T3 and the 4^{th} nanosheet transistor T4 may be formed at a 2^{nd} level above the 1^{st} level in the D3 direction, and isolated from each other by the isolation wall 119. Thus, the 3^{rd} nanosheet transistor T3 may be formed above the 1^{st} nanosheet transistor T1 at a left side of the isolation wall 119, and the 4^{th} nanosheet transistor T4 may be formed above the 2^{nd} nanosheet transistor T2 at a right side of the isolation wall 119.

In the 3D-stacked semiconductor device 10, the 1^{st} nanosheet transistor T1 and the 3^{rd} nanosheet transistor T3 may form a left-side stacked nanosheet transistor structure, and the 2^{nd} nanosheet transistor T2 and the 4^{th} nanosheet transistor T4 may form a right-side stacked nanosheet transistor structure.

The 1^{st} nanosheet transistor T1 may include 1^{st} active layers 110A as a 1^{st} channel structure, a 1^{st} gate structure 117A surrounding the 1^{st} active layers 110A, and 1^{st} source/drain patterns 115A formed on the 1^{st} channel structure. The 1^{st} source/drain patterns 115A may have been epitaxially grown from the 1^{st} active layers 110A in a process of manufacturing the 3D-stacked semiconductor device 10. Similarly, the 2^{nd} nanosheet transistor T2 may include 2^{nd} active layers 110B as a 2^{nd} channel structure, a 2^{nd} gate structure 117B surrounding the 2^{nd} active layers 110B, and 2^{nd} source/drain patterns 115B formed on the 2^{nd} channel structure. The 2^{nd} source/drain patterns 115B may have been epitaxially grown from the 2^{nd} active layers 110B in the process of manufacturing the 3D-stacked semiconductor device 10.

The 3^{rd} nanosheet transistor T3 may include 3^{rd} active layers 120A as a 3^{rd} channel structure, a 3^{rd} gate structure 127A surrounding the 3^{rd} active layers 120A, and 3^{rd} source/drain patterns 125A formed on the 3^{rd} channel structure. The 3^{rd} source/drain patterns 125A may have been epitaxially grown from the 3^{rd} active layers 120A in the process of manufacturing the 3D-stacked semiconductor device 10. Similarly, the 4^{th} nanosheet transistor T4 may include 4^{th} active layers 120B as a 4^{th} channel structure, a 4^{th} gate structure 127B surrounding the 4^{th} active layers 120B, and 4^{th} source/drain patterns 125B formed on the 4^{th} channel structure. The 4^{th} source/drain patterns 125B may have been epitaxially grown from the 4^{th} active layers 120B in the process of manufacturing the 3D-stacked semiconductor device 10.

The substrate 101 may be a silicon (Si) substrate although it may include other materials such as silicon germanium (SiGe), silicon carbide (SiC), not being limited thereto. The active layers 110A, 110B, 120A and 120B may have been epitaxially grown from the substrate 101, and thus, may be formed of or include the same material (e.g., Si) forming the substrate 101.

The 1^{st} to 4^{th} source/drain patterns 115A, 115B, 125A and 125B are isolated from each other through an interlayer dielectric (ILD) layer 108 which may be formed of a low-k dielectric material such as silicon oxide (e.g., SiO₂), not being limited thereto.

On an upper-left corner and an upper-right corner may be formed a shallow trench isolation (STI) structure 103 which may isolate an active region of the substrate 101, based on which the active layers 110A, 110B, 120A and 120B are epitaxially grown, from an active region of another 3D-stacked semiconductor device formed at each side of the 3D-stacked semiconductor device 10. The STI structure 103 may include silicon oxide (e.g., SiO₂), not being limited thereto.

Each of the 1^{st} to 4^{th} source/drain patterns 115A, 115B, 125A and 125B may be formed of or include silicon (Si) or silicon germanium (SiGe), and may have been doped in-situ with p-type impurities (e.g., boron, gallium, or indium) or n-type impurities (e.g., phosphorus, arsenic, or antimony). For example, in a case where the 1^{st} nanosheet transistor T1 is of an n-type and the 3^{rd} nanosheet transistor T3 is of a p-type, the 1^{st} source/drain patterns 115A may be formed of silicon (Si) doped with boron, and the 3^{rd} source/drain patterns 125A may be formed of silicon germanium (SiGe) doped with phosphorus.

Each of the 1^{st} to 4^{th} gate structures 117A, 117B 127A and 127B may include a gate dielectric layer, a work-function metal layer, and a gate electrode. The gate dielectric layer may include an interfacial layer formed of an oxide material such as silicon oxide (e.g., SiO, SiO₂, etc.) and/or silicon oxynitride (e.g., SiON), not being limited thereto. The gate dielectric layer may further include a high-k layer formed of a high-k material such as Hf, Al, Zr, La, Mg, Ba, Ti, Pb, and/or a combination thereof, not being limited thereto. The work-function metal layer may be formed of a metal such as Cu, Al, Ti, Ta, W, Co, TiN, WN, TiAl, TiAlN, TaN, TiC, TaC, TiAlC, TaCN, TaSiN, and/or a combination thereof, not being limited thereto. However, the work-function metal layers of the 1^{st} gate structure 117A and the 3^{rd} gate structure 127A may be different from each other in the case where the 1^{st} nanosheet transistor T1 is of an n-type and the 3^{rd} nanosheet transistor T3 is of a p-type so that they may have different gate threshold voltages. The gate electrode of each of the 1^{st} to 4^{th} gate structures 117A, 117B 127A and 127B may be formed of Cu, W, Al, Ru, Mo, Co, and/or a combination thereof, not being limited thereto.

On the 1^{st} to 4^{th} source/drain patterns 115A, 115B, 125A and 125B may be formed 1^{st} to 4^{th} active contacts CR1, CR2, CA1 and CA2, respectively, which connect the 1^{st} to 4^{th} source/drain patterns 115A, 115B, 125A and 125B to one or more voltage sources to power one or more of the 1^{st} to 4^{th} transistors T1-T4 and/or other circuit elements for signal routing purposes though metal lines formed above the 3D-stacked semiconductor device 10 in the D3 direction. The 1^{st} to 4^{th} active contacts CR1, CR2, CA1 and CA2 may each be formed of one or more conductive materials such as Cu, W, Al, Ru, Mo, Co, and/or a combination thereof, not being limited thereto. Although FIG. 1A shows that all of the 1^{st} to 4^{th} source/drain patterns 115A, 115B, 125A and 125B have respective active contacts thereon, one or more of these active contacts may not be formed depending on a circuit design.

Referring to FIGS. 1A-1C, the 3^{rd} active layers 120A may be formed to have a smaller width than the 1^{st} active layers 110A formed therebelow, and the 4^{th} active layers 120B may be formed to have a smaller width than the 2^{nd} active layers 110B. Due to this width difference in the active layers forming the respective channel structures, the 3^{rd} source/drain pattern 125A grown from the 3^{rd} active layers 120A may have a smaller width than the 1^{st} source/drain pattern 115A, and the 4^{th} source/drain pattern 125B grown from the 4^{th} active layers 120B may have a smaller width than the 2^{nd} source/drain pattern 115B.

Further, due to these differences in the active layers and the source/drain patterns, a 1^{st} active contact CR1 may be formed on a top surface of the 1^{st} source/drain pattern 115A at a non-overlapping portion where the 1^{st} source/drain pattern 115A is not vertically overlapped by the 3^{rd} source/drain pattern 125A in the D3 direction. Similarly, a 2^{nd} active contact CR2 may be formed on a top surface of the 2^{nd} source/drain pattern 115B of the 2^{nd} nanosheet transistor T2 at a non-overlapping portion where the 2^{nd} source/drain pattern 115B is not vertically overlapped by the 4^{th} source/drain pattern 125B in the D3 direction. In contrast, left side surfaces of the 1^{st} active layers 110A and the 3^{rd} active layers 120A may be vertically aligned, and right side surfaces of the 2^{nd} active layers 110B and the 4^{th} active layers 120B may be vertically aligned. Accordingly, left side surfaces of the 1^{st} source/drain pattern 115A and the 3^{rd} source/drain pattern 125A may be vertically aligned, and right side surfaces of the 4^{th} source/drain pattern 125B and the 2^{nd} source/drain pattern 115B may be vertically aligned.

In the meantime, the isolation wall 119 as described above may be formed to electrically isolate the 1^{st} nanosheet transistor T1 and the 2^{nd} nanosheet transistor T2 from each other and also electrically isolate the 3^{rd} nanosheet transistor T3 from the 4^{th} nanosheet transistor T4 from each other. For example, the isolation wall 119 may isolate the 1^{st} channel structure including the 1^{st} active layers 110A from the 2^{nd} channel structure including the 2^{nd} active layers 110B, and may also isolate the 1^{st} source/drain pattern 115A from the 2^{nd} source/drain pattern 115B. The isolation wall 119 may also be formed such that a right side surface of each of the 1^{st} active layers 110A contacts a left side surface of the isolation wall 119, and a left side surface of each of the 2^{nd} active layers 110B contacts a right side surface of the isolation wall 119. Accordingly, a right side surface of the 1^{st} source/drain pattern 115A may contact the left side surface of the isolation wall 119, and a left side surface of the 2^{nd} source/drain pattern 115B may contact the right side surface of the isolation wall 119. However, the 3^{rd} active layers 120A, the 3^{rd} source/drain pattern 125A, the 4^{th} active layers 120B, and the 4^{th} source/drain pattern 125B may not contact the isolation wall 119 due to the respective non-overlapping regions.

Further, as shown in FIGS. 1A and 1B, the isolation wall 119 may isolate the 1^{st} gate structure 117A from the 2^{nd} gate structure 117B, and isolate the 3^{rd} gate structure 127A from the 4^{th} gate structure 127B. However, the disclosure is not limited thereto. According to one or more other embodiments, a top surface of the isolation wall 119 may be formed to be lower than a top surface of each of the 3^{rd} gate structure 127A and the 4^{th} gate structure 127B and the gate electrodes of these to gate structures 127A and 127B may be connected to each other.

The isolation wall 119 may be formed of a dielectric material such as silicon nitride (e.g., SiN) to serve as a dielectric barrier between two parallel nanosheet transistors T1 and T2. For example, the 1^{st} nanosheet transistor T1 may be of an n-type and the 2^{nd} nanosheet transistor T2 may be of a p-type. Due to this isolation wall 119, the two opposite-polarity nanosheet transistors T1 and T2 may be formed to be closer in the D1 direction without causing capacitance-related issues, which would otherwise impact performance and power consumption of the 3D-stacked semiconductor device 10. Further, the isolation wall 119 may enable the 3D-stacked semiconductor device 10 to achieve an additional area gain without a short-circuit risk between the two parallel nanosheet transistors T1 and T2.

In FIGS. 1A and 1B, the 3D-stacked semiconductor device 10 is formed such that the two non-overlapping regions where the 1^{st} active contact CR1 and the 2^{nd} active contact CR2 are formed face each other with the isolation wall 119 therebetween. However, the disclosure is not limited thereto. According to one or more other embodiments, a 3D-stacked semiconductor device 10 including forksheet transistors may have different forms as long as the isolation wall 119 is formed to isolate two parallel nanosheet transistors T1 and T2 form each other.

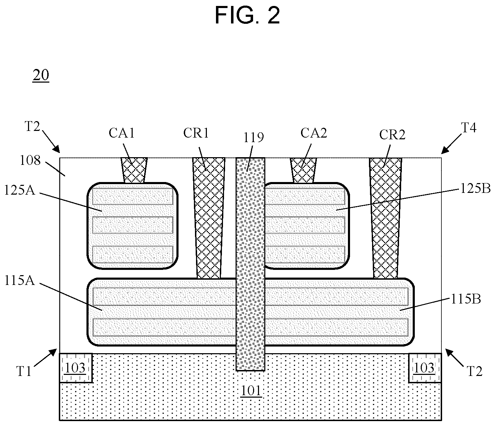

FIG. 2 illustrates a 3D-stacked semiconductor device including forksheet transistors with active contacts thereon, according to one or more other embodiments.

Referring to FIG. 2, a 3D-stacked semiconductor device 20 may have the same structural elements as those of the 3D-stacked semiconductor device 10 of FIGS. 1A-1C except that, in the 3D-stacked semiconductor device 20, the 4^{th} nanosheet transistor T4 above the 2^{nd} nanosheet transistor T2 may be formed at the same position as the 3^{rd} nanosheet transistor T3 above the 1^{st} nanosheet transistor T1. For example, the left side surface of each of the 4^{th} active layers 120B and the left side surface of the 4^{th} source/drain pattern 125B may contact the right side surface of the isolation wall 119 in addition that the left side surface of each of the 2^{nd} active layers 110B and the left side surface of the 2^{nd} source/drain pattern 115B contact the right side surface of the isolation wall 119.

Thus, compared to the 3D-stacked semiconductor device 10 shown in FIGS. 1A and 1B, the 3D-stacked semiconductor device 20 may have different device characteristics at least because of the different 4^{th} nanosheet transistor T4 of which the 4^{th} gate structure 127B may not be formed on the left side surface of each of the 4^{th} active layers 120B.

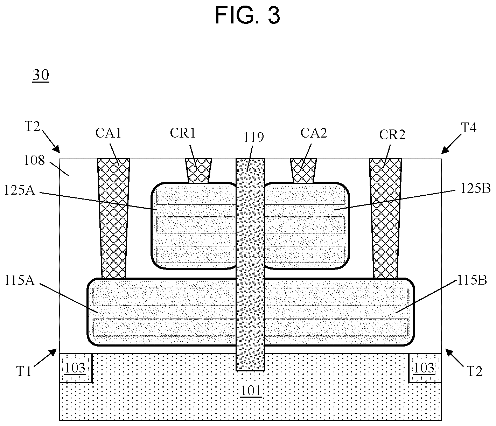

FIG. 3 illustrates a 3D-stacked semiconductor device including forksheet transistors with active contacts thereon, according to one or more other embodiments.

Referring to FIG. 3, a 3D-stacked semiconductor device 30 may have the same structural elements as those of the 3D-stacked semiconductor device 10 of FIGS. 1A-1C except that, in the 3D-stacked semiconductor device 30, the left side surface of each of the 4^{th} active layers 120B and the left side surface of the 4^{th} source/drain pattern 125B may contact the right side surface of the isolation wall 119, and further, the right side surface of each of the 3^{rd} active layers 120A and the right side surface of the 3^{rd} source/drain pattern 125A may also contact the left side surface of the isolation wall 119.

Thus, compared to the 3D-stacked semiconductor devices 10 and 20 shown in FIGS. 1A-1C and 2, the 3D-stacked semiconductor device 30 may have different device characteristics at least because of the different 3^{rd} nanosheet transistor T3 and 4^{th} nanosheet transistor T4. In the 3D-stacked semiconductor device 30, the 3^{rd} gate structure 127A may not be formed the right side surface of each of the 3^{rd} active layers 120A, the 4^{th} gate structure 127B may not be formed on the left side surface of each of the 4^{th} active layers 120B.

In the meantime, while the forksheet transistor structure may provide further miniaturization of the 3D-stacked semiconductor device 30 by reducing a distance between two parallel nanosheet transistors (e.g., the nanosheet transistors T1 and T2) using the isolation wall 119 therebetween, there may still be a risk of short-circuit between the 1^{st} active contact CR1 and the 3^{rd} source/drain pattern 125A and between the 2^{nd} active contact CR2 and the 4^{th} source/drain pattern 125B in the nanometer-scale device. Further, the 3D-stacked semiconductor device 30 may be limited to achieve an additional area gain because of the non-overlapping regions where the 1^{st} active contact CR1 and the 2^{nd} active contact CR2 should be formed. Thus, the following embodiments provide a 3D-stacked semiconductor device including forksheet transistors having an improved active contact structure to achieve an additional area gain.

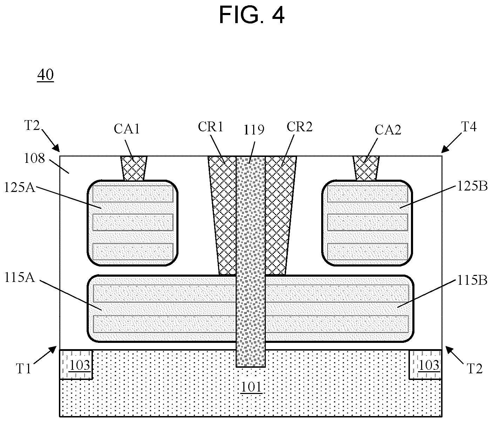

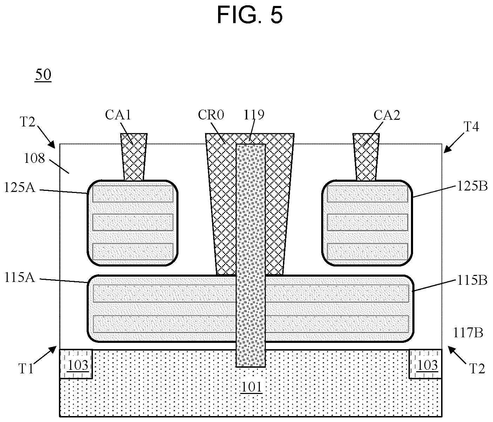

FIGS. 4 and 5 illustrate 3D-stacked semiconductor devices including forksheet transistors with active contacts contacting an isolation wall, according to one or more other embodiments.

Referring to FIG. 4, a 3D-stacked semiconductor device 40 may have the same structural elements as those of the 3D-stacked semiconductor device 10 of FIGS. 1A-1C except that, in the 3D-stacked semiconductor device 40, the 1^{st} active contact CR1 and the 2^{nd} active contact CR2 may each be formed to contact the isolation wall 119. For example, the right side surface of the 1^{st} active contact CR1 may contact the left side surface of the isolation wall 119, and the left side surface of the 2^{nd} active contact CR2 may contact the right side surface of the isolation wall 119. Still, the two active contacts CR1 and CR2 may be able to make sufficient contact on the 1^{st} source/drain pattern 115A and the 2^{nd} source/drain pattern 115B, respectively.

While the 3D-stacked semiconductor device 10 of FIGS. 1A-1C is formed such that a space is provided between the isolation wall 119 and each of the 1^{st} active contact CR1 and the 2^{nd} active contact CR2, the 3D-stacked semiconductor device 40 of FIG. 4 may be formed such that no space is provided between the isolation wall 119 and each of the 1^{st} active contact CR1 and the 2^{nd} active contact CR2. Still, however, these two active contacts CR1 and CR2 can be isolated from each other due to the isolation wall 119.

As the two active contacts CR1 and CR2 can be formed further away from the 1^{st} source/drain pattern 115A and the 2^{nd} source/drain pattern 115B, respectively, the short-circuit risk between therebetween may be further reduced. In addition, the active layers 120A and 120B may be formed to be close to the isolation wall 119 as much as the active contacts CR1 and CR2 are moved to contact the isolation wall 119, thereby achieving an additional area gain, compared to the 3D-stacked semiconductor device 10 of FIGS. 1A-1C.

Further, the two active contacts CR1 and CR2 may be formed in a single step of deposition when the 3D-stacked semiconductor device 40 is manufactured, as will be described later, a manufacturing process may be simplified.

Moreover, the two active contacts CR1 and CR2 may be formed as a single continuum structure in a completed 3D-stacked semiconductor device as shown in FIG. 5 as described below.

Referring to FIG. 5, a 3D-stacked semiconductor device 50 including forksheet transistors with active contacts thereon may have the same structural elements as those of the 3D-stacked semiconductor device 40 of FIG. 4 except that, in the 3D-stacked semiconductor device 50, a single shared active contact CR0 is formed to surround the isolation wall 119 and contact the top surface, the left side surface and the right side surface of the isolation wall 119 as well as the top side surfaces of the 1^{st} source/drain pattern 115A and the 2^{nd} source/drain pattern 115B.

This configuration of the single shared active contact CR0 may be provided to form, for example, a complementary metal-oxide-semiconductor (CMOS) device such as an inverter circuit where the 1^{st} source/drain pattern 115A as a drain of the 1^{st} nanosheet transistor T1 is connected to the 2^{nd} source/drain pattern 115B as a drain of the 2^{nd} nanosheet transistor T2.

Still, the 3D-stacked semiconductor device 50 may achieve a similar area gain and simplicity of a manufacturing process, and further, reduce a short-circuit risk between the active contact CR0 and each of the 3^{rd} source/drain pattern 125A and the 4^{th} source/drain pattern 125B.

Herebelow, a method of manufacturing a 3D-stacked semiconductor device including forksheet transistors corresponding to the 3D-stacked semiconductor device 40 may be provided.

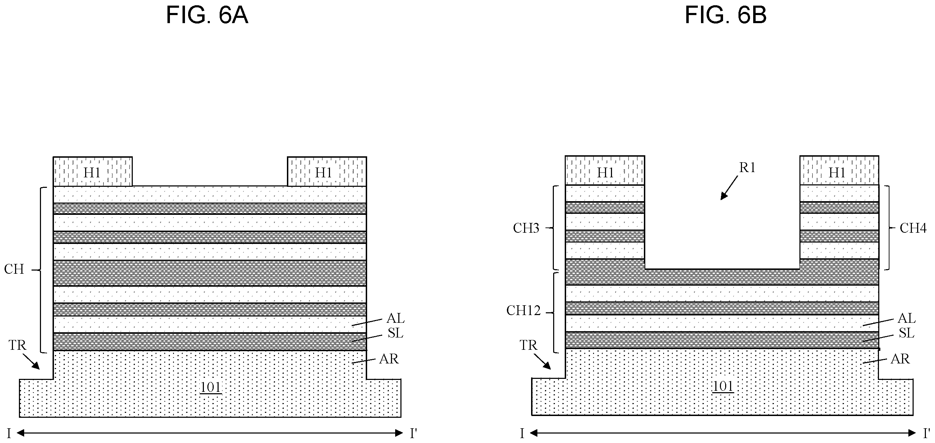

FIGS. 6A through 6L illustrate cross-section views of intermediate 3D-stacked semiconductor devices after respective steps of manufacturing a 3D-stacked semiconductor device including forksheet transistors with active contacts contacting an isolation wall, according to one or more embodiments. The 3D-stacked semiconductor device manufactured through the respective steps may be or correspond to the 3D-stacked semiconductor device 10 shown in FIGS. 1A-1C, and thus, the cross-section views of the intermediate 3D-stacked semiconductor device may correspond to those shown in FIG. 1B or 1C taken along lines I-I' or II-II', respectively. Further, duplicate descriptions about the same structural elements described above in reference to FIGS. 1A-1C may be omitted and the same reference characters or numerals may be used herebelow for brevity purposes.

Referring to FIG. 6A, a substrate 101 may be patterned to form two shallow trenches at both sides thereof and define an active region AR between the two shallow trenches, and a channel stack CH may be formed on the active region AR.

The channel stack CH may be formed by epitaxially growing a plurality of nanosheet layers on the active region AR in the D3 direction. For example, a sacrificial layer SL of silicon germanium (SiGe) and an active layer AL of silicon (Si) may be epitaxially grown one after another in an alternating manner on the active region AR until a desired number of layers are obtained for the channel stack CH. The epitaxy performed in this step may include molecular beam epitaxy, vapor-phase epitaxy (VPE), etc., not being limited thereto.

On the channel stack CH at selected positions may be formed 1^{st} hard mask patterns H1 exposing a top surface of the channel stack CH to be etched down in a next step. The hard mask patterning may be performed through, for example, photolithography. The 1^{st} hard mask patterns H1 may be formed of a material such as silicon nitride (e.g., SiN), silicon oxide (e.g., SiO₂), etc., not being limited thereto.

Referring to FIG. 6B, the channel stack CH may be etched back based on the 1^{st} hard mask patterns H1 by a predetermined depth to obtain a recess R1 which defines a lower channel stack CH12, an upper-left channel stack CH3, and an upper-right channel stack CH4.

In a later step, the lower channel stack CH12 is to be formed as channel structures of the 1^{st} nanosheet transistor T1 and the 2^{nd} nanosheet transistor T2 shown in FIGS. 1A-1C, and the upper-left channel stack CH3 and the upper-right channel stack CH4 are to be formed as respective channel structures of the 3^{rd} nanosheet transistor T3 and the 4^{th} nanosheet transistor T4 also shown in FIGS. 1A-1C.

The etching operation performed in this step may include dry etching or wet etching using an etchant selectively etching the sacrificial layers SL and the active layers AL of the channel stack CH based on the 1^{st} hard mask patterns H1.

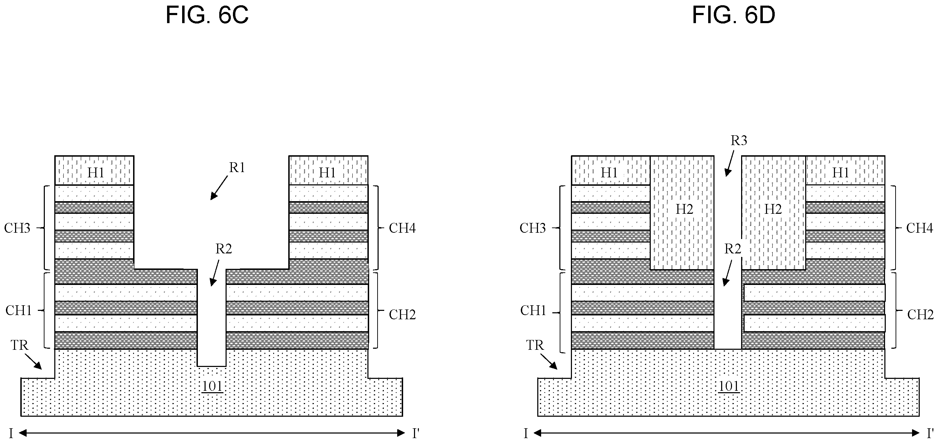

Referring to FIG. 6C, the lower channel stack CH12 obtained in the previous step may be etched back by a predetermined depth to obtain a recess R2 which penetrates into the substrate 101 and divide the lower channel stack CH12 into a lower-left channel stack CH1 and a lower-right channel stack CH2 to be formed as respective channel structures of the 1^{st} nanosheet transistor T1 and the 2^{nd} nanosheet transistor T2 shown in FIGS. 1A-1C in a later step.

The etching operation to form the recess R2 in this step may be performed by forming 2^{nd} hard mask patterns on selected positions at a top surface of the lower channel stack CH12 exposed through the recess R1 in the previous step, and performing dry etching or wet etching on the lower channel stack CH12 based on the 2^{nd} hard mask patterns. After the recess R2 is formed, the 2^{nd} hard mask patterns may be removed through, for example, ashing or stripping, not being limited thereto. The recess R2 obtained by the etching operation in this step is to be filled in with a dielectric material to form the isolation wall 119 shown in FIGS. 1A-1C in a later step.

Referring to FIG. 6D, two 2^{nd} hard mask patterns H2 may be formed on top surfaces of the lower-left channel stack CH1 and the lower-right channel stack CH2 exposed through the recess R1 obtained in the previous step.

Thus, a recess R3 may be formed between the two 2^{nd} hard mask patterns H2, and this recess R3 may be connected to the recess R2 formed between the lower-left channel stack CH1 and the lower-right channel stack CH2.

Like the 1^{st} hard mask patterns H1, the 2^{nd} hard mask patterns H2 may be formed of a material such as silicon nitride (e.g., SiN), silicon oxide (e.g., SiO₂), etc., not being limited thereto, and the hard mask patterning may be performed through, for example, photolithography.

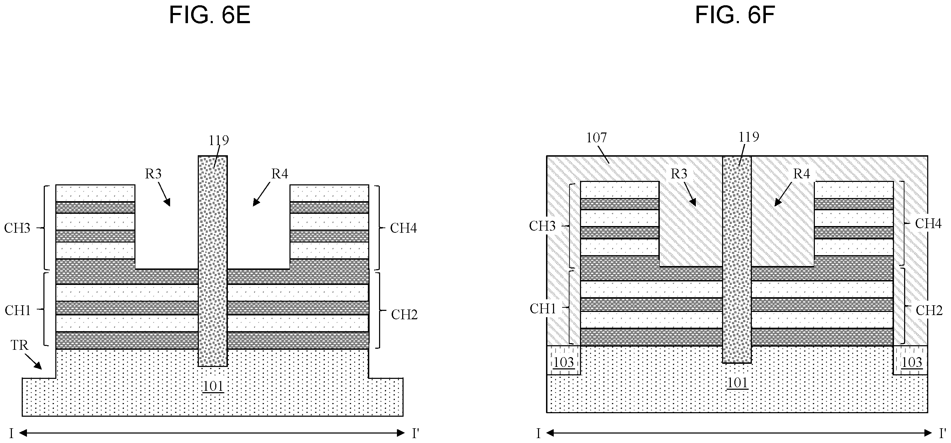

Referring to FIG. 6E, the recesses R2 and R3 obtained in the previous steps may be filled in with an isolation wall 119 formed of a dielectric material such as silicon nitride (e.g., SiN) through, for example, physical vapor deposition (PVD), chemical vapor deposition (CVD), plasma enhanced chemical vapor deposition (PECVD), or combinations thereof, not being limited thereto, followed by planarization such as chemical-mechanical polishing (CMP). Here, the isolation wall 119 may also be formed to extend in the D1 direction, that is, the channel-length direction, in the recesses R2 and R3.

Further, the channel stacks CH1-CH4 may be patterned along the D1 direction to provide spaces where source/drain patterns are to be formed in a later step. The patterning of the channel stacks CH1-CH4 in this step may be performed through, for example, another photolithography, masking and etching operations. At this time, the isolation wall 119 may not be patterned, and thus, a length of the isolation wall 119 may be longer than lengths of the patterned channel stacks CH1-CH4, in the D1 direction.

After formation of the isolation wall 119 in the recesses R2 and R3, the 1^{st} hard mask patterns H1 and the 2^{nd} hard mask patterns H2 may be removed through, for example, ashing or stripping, not being limited thereto.

Referring to FIG. 6F, a shallow trench isolation (STI) structure 103 may be formed in the shallow trenches TR and a dummy gate structure 107 may be formed to surround the channel stacks CH1-CH4.

The dummy gate structure 107 may be formed through, for example, depositing polycrystalline silicon (p-Si) or amorphous silicon (a-Si) on the channel stacks CH1-CH4. The deposition may be PVD, CVD, PECVD, or a combination thereof, not being limited thereto. Further, a CMP operation may be performed on the dummy gate structure 107 such that top surfaces of the dummy gate structure 107 and the isolation wall 119 may be coplanar or horizontally aligned.

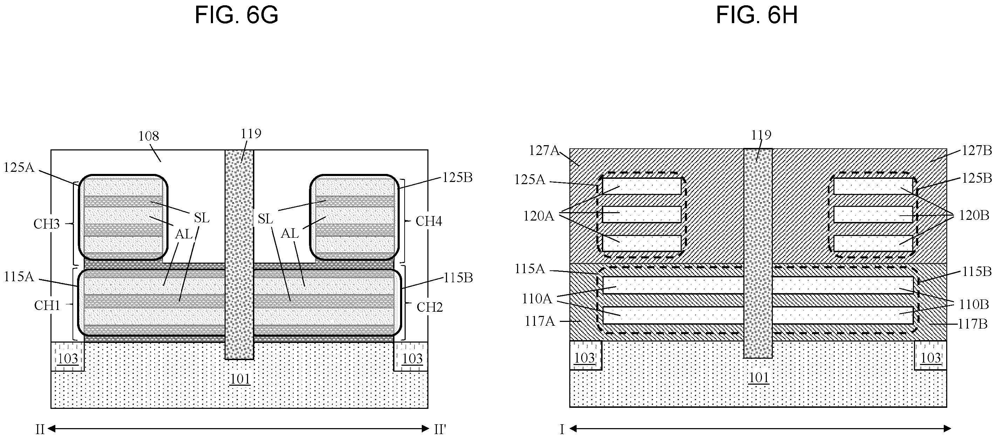

Referring to FIG. 6G which is a cross-section view corresponding to that taken along lines II-II' of FIG. 1A, the 1^{st} to 4^{th} source/drain patterns 115A, 115B, 125A and 125B may be formed on both sides of the lower-left channel stack CH1, the lower-right channel stack CH2, the upper-left channel stack CH3 and the upper-right channel stack CH4 in the D1 direction.

For example, the 1^{st} to 4^{th} source/drain patterns 115A, 115B, 125A and 125B may be epitaxially grown from the active layers AL in the lower-left channel stack CH1, the lower-right channel stack CH2, the upper-left channel stack CH3 and the upper-right channel stack CH4 in the D1 direction. The 1^{st} to 4^{th} source/drain patterns 115A, 115B, 125A and 125B may each be formed of silicon (Si) or silicon germanium (SiGe), and may be doped in-situ with p-type impurities (e.g., boron, gallium, or indium) or n-type impurities (e.g., phosphorus, arsenic, or antimony). For example, the 1^{st} source/drain patterns 115A may be formed of silicon (Si) doped with boron, and the 3^{rd} source/drain patterns 125A may be formed of silicon germanium (SiGe) doped with phosphorus.

Further, an ILD layer 108 may be formed to isolate the 1^{st} to 4^{th} source/drain patterns 115A, 115B, 125A and 125B from each other and surround the isolation wall 119, followed by planarization by, for example, CMP, so that a top surface of the ILD layer 108 may be horizontally aligned with or coplanar with the top surface of the isolation wall 119. The ILD layer 108 may include a low-k dielectric material such as silicon oxide (e.g., SiO₂), not being limited thereto.

Referring to FIG. 6H, the dummy gate structure 107 formed in the previous step (FIG. 6F) may be removed along with the sacrificial layers SL of the channel stacks CH1-CH4 through dry etching (e.g., reactive ion etching) or wet etching (e.g., chemical oxide removal). Further, spaces provided by the removal of the dummy gate structure 107 and the sacrificial layers SL may be filled in with 1^{st} to 4^{th} gate structures 117A, 117B, 127A and 127B through, for example, atomic layer deposition (ALD), PEALD, CVD, PVD, or a combination thereof, not being limited thereto.

To form each of the 1^{st} to 4^{th} gate structures 117A, 117B 127A and 127B, a gate dielectric layer, a work-function metal layer, and a gate electrode may be sequentially on each of the active layers AL of the channel stacks CH1-CH4. Thus, 1^{st} to 4^{th} active layers 110A, 110B, 120A and 120B respectively forming 1^{st} to 4^{th} channel structures may be surrounded by the 1^{st} to 4^{th} gate structures 117A, 117B 127A and 127B, respectively.

Thus, in this step, a 3D-stacked semiconductor device of forksheet transistor structure may be formed by the 1^{st} to 4^{th} nanosheet transistors T1-T4 along with the isolation wall 119.

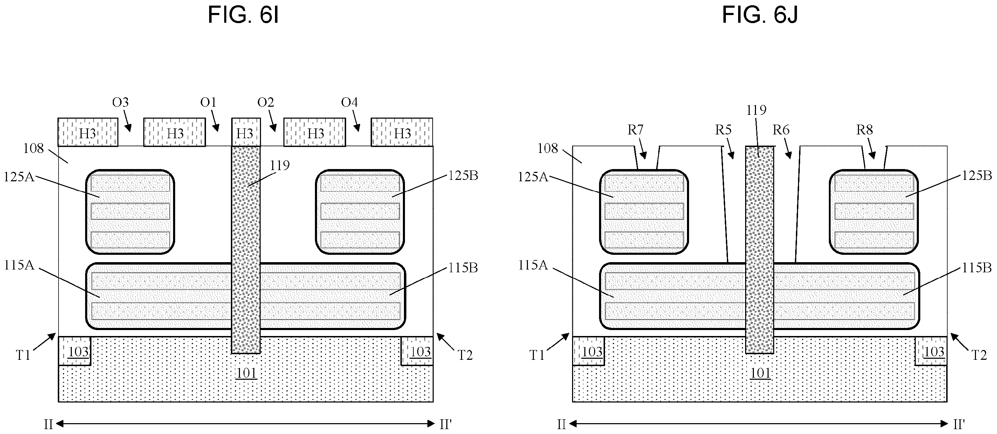

Referring to FIG. 6I which is a cross-section view corresponding to that taken along lines II-II' of FIG. 1A, 3^{rd} hard mask patterns H3 may be formed on the isolation wall 119 and the ILD layer 108 to expose the top surface of the ILD layer 108 through openings 01-04.

The openings 01-04 may be aligned with top surfaces of the 1^{st} to 4^{th} source/drain patterns 115A, 115B, 125A and 125B, respectively, so that the ILD layer 108 is to be etched through the openings 01-04 for formation of corresponding active contacts in a next step. The openings O1 and O2 may be formed at two opposite sides of a 3^{rd} hard mask pattern H3 formed on the top surface of the isolation wall 119 so that the ILD layer 108 may be etched down along the isolation wall 119 to reach the 1^{st} source/drain pattern 115A and the 2^{nd} source/drain pattern 115B in a next step.

Like the 1^{st} hard mask patterns H1, the 3^{rd} hard mask patterns H3 may be formed of a material such as silicon nitride (e.g., SiN), silicon oxide (e.g., SiO₂), etc., not being limited thereto, and the hard mask patterning may be performed through, for example, photolithography.

Referring to FIG. 6J, the ILD layer 108 may be etched based on the 3^{rd} hard mask patterns H3 with the openings 01-04 through, for example, dry etching or wet etching, to form recesses R5-R8 which expose top surfaces of the 1^{st} to 4^{th} source/drain patterns 115A, 115B, 125A and 125B, respectively, where active contacts are to be formed in a next step.

Here, as the openings O1 and O2 are formed at the two opposite sides of the 3^{rd} hard mask pattern H3 on the top surface of the isolation wall 119 in the previous step, the corresponding recesses R5 and R6 expose a left side surface and a right side surface of the isolation wall 119 as well as the top surfaces of the 1^{st} source/drain pattern 115A and the 2^{nd} source/drain pattern 115B.

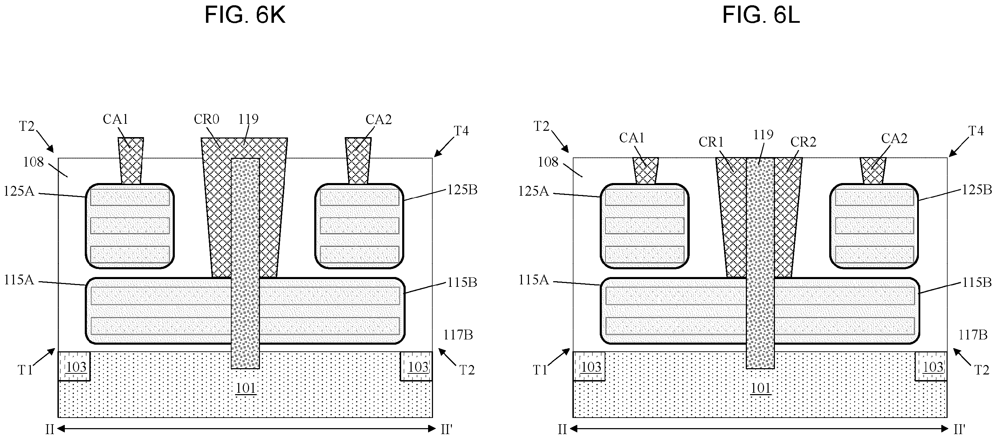

Referring to FIG. 6K, the recesses R5-R8 obtained in the previous step may be filled in with active contacts CR0, CA1 and CA2 through, for example, performing PVD, CVD, PECVD, or a combination thereof using a metal such as Cu, W, Al, Ru, Mo, Co, or a combination thereof, not being limited thereto.

Thus, the active contact CR0 may be formed along the left and right side surfaces of the isolation wall 119 to contact these side surfaces as well as the top surfaces of the 1^{st} source/drain pattern 115A and the 2^{nd} source/drain pattern 115B in the recesses R5 and R6. Further, the active contacts CA1 and CA2 may be formed in the recesses R7 and R8 to contact the top surfaces of the 3^{rd} source/drain pattern 125A and the 4^{th} source/drain pattern 125B, respectively.

Prior to formation of the metal or the metal compound in the recesses R5-R8, a barrier metal layer may be layered in the recesses R5-R8 through, for example, atomic layer deposition (ALD) to prevent the metal or metal compound from being diffused into the ILD layer 108. For example, a material forming the barrier metal layer may be titanium (Ti), titanium nitride (TiN), tantalum (Ta), tantalum nitride (TaN), etc.

Thus, the active contacts CR0, CA1 and CA2 may also include this barrier metal layer, and the metal or the metal compound forming the active contacts CR0 may contact the side surfaces of the isolation wall 119 through the barrier metal layer.

Referring to FIG. 6L, portions of the active contacts CR0, CA1 and CA2 formed above the top surfaces of the ILD layer 108 and the isolation wall 119 may be removed as necessary through, for example, CMP. As a portion of the active contact CR0 formed above the top surface of the isolation wall 119 is removed, the active contact CR0 may be divided into a 1^{st} active contact CR1 and a 2^{nd} active contact CR2 isolated from each other through the isolation wall 119.

Here, the 3D-stacked semiconductor device shown in FIG. 6K corresponds to the 3D-stacked semiconductor device 50 shown in FIG. 5, the 3D-stacked semiconductor device shown in FIG. 6L may correspond to the 3D-stacked semiconductor device 40 shown in FIG. 4.

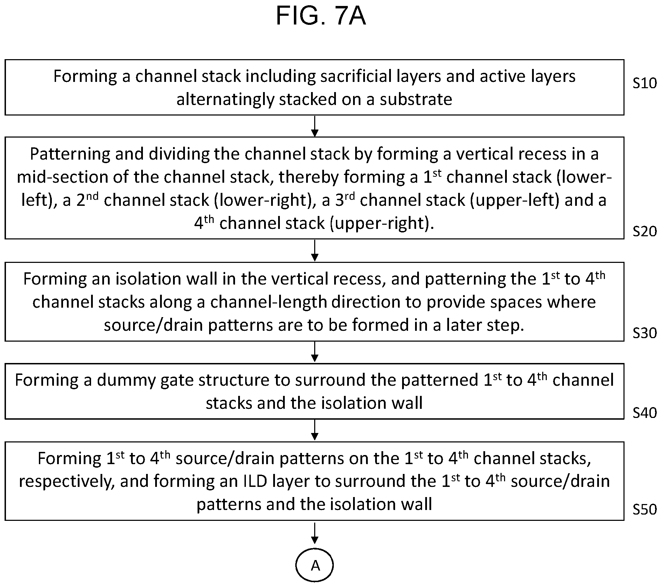

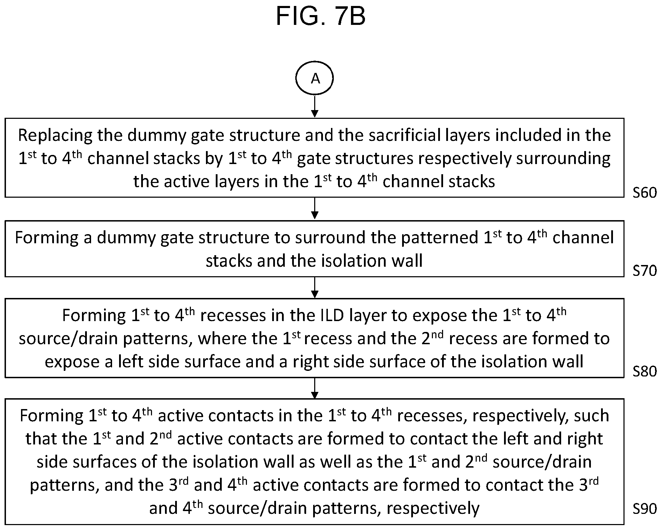

FIGS. 7A and 7B illustrate a flowchart of a method of manufacturing a 3D-stacked semiconductor device including forksheet transistors with active contacts contacting an isolation wall, according to one or more embodiments.

In step S 10, a channel stack including a plurality of nanosheet layers may be formed on a substrate. The nanosheet layers may include a plurality of sacrificial layers and active layers alternatingly stacked on the substrate. The sacrificial layers may be formed of silicon germanium (SiGe) while the active layers may be formed of silicon (Si).

In step S20, the channel stack may be patterned and divided by forming a vertical recess in a mid-section of the channel stack, thereby forming a 1^{st} channel stack (lower-left channel stack), a 2^{nd} channel stack (lower-right channel stack), a 3^{rd} channel stack (upper-left channel stack) and a 4^{th} channel stack (upper-right channel stack). The vertical recess may penetrate the channel stack in a vertical direction (D3 direction) and extended in a channel-length direction in the vertical recess.

In step S30, an isolation wall may be formed in the vertical recess, and the 1^{st} to 4^{th} channel stacks may be patterned along a channel-length direction (D1 direction) to provide spaces where source/drain patterns are to be formed in a later step.

In step S40, a dummy gate structure may be formed to surround the patterned 1^{st} to 4^{th} channel stacks and the isolation wall.

In step S50, 1^{st} to 4^{th} source/drain patterns may be formed on the 1^{st} to 4^{th} channel stacks, respectively, and an ILD layer may be formed to surround the 1^{st} to 4^{th} source/drain patterns and the isolation wall.

In step S60, the dummy gate structure along with the sacrificial layers included in the 1^{st} to 4^{th} channel stacks may be replaced by 1^{st} to 4^{th} gate structures respectively surrounding each of the active layers in the 1^{st} to 4^{th} channel stacks. Thus, the active layers respectively surrounded by the 1^{st} to 4^{th} gate structures may form 1^{st} to 4^{th} channel structures for a 3D-stacked semiconductor device.

In step S70, 1^{st} to 4^{th} recesses may be formed in the ILD layer to expose the 1^{st} to 4^{th} source/drain patterns. Here, the 1^{st} recess and the 2^{nd} recess may be formed along a left side surface and a right side surface of the isolation wall to expose these side surfaces through the 1^{st} and 2^{nd} recesses.

In step S80, 1^{st} to 4^{th} active contacts may be formed in the 1^{st} to 4^{th} recesses, respectively, such that the 1^{st} active contact and the 2^{nd} active contact are formed to contact the left side surface and the right side surface of the isolation wall as well as the 1^{st} source/drain pattern and the 2^{nd} source/drain pattern, and the 3^{rd} active contact and the 4^{th} active contact are formed to contact the 3^{rd} source/drain pattern and the 4^{th} source/drain pattern, respectively.

Through the above method and process, a 3D-stacked semiconductor device including a forksheet transistor structure may have an active contact formed on side surfaces of an isolation wall, thereby reducing a risk of short-circuit and achieving an additional area gain.

In the above embodiments, active contacts formed alongside surfaces of an isolation wall are formed on source/drain patterns of a lower transistor in a 3D-stacked forksheet transistor structure which is a multi-stack semiconductor device. However, the disclosure is not limited thereto. According to one or more other embodiments, an active contact may be formed on only one side surface of an isolation wall, and the active contact may be formed on a source/drain pattern of a transistor in a single-stack semiconductor device. Further, the active contact formed along a side surface of an isolation wall may be formed to contact a source/drain pattern of an upper transistor in a 3D-stacked semiconductor device.

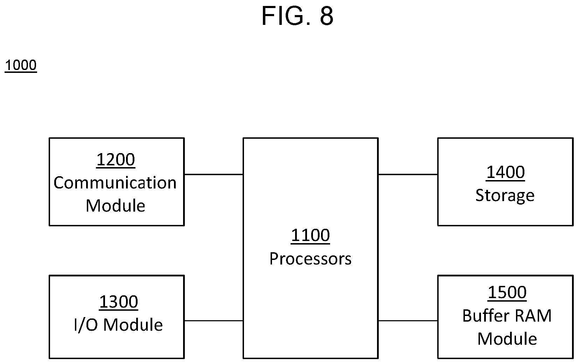

FIG. 8 is a schematic block diagram illustrating an electronic device including a semiconductor device of a forksheet transistor structure in which one or more active contacts are formed along one or more side surfaces of an isolation wall, according to one or more embodiments. This semiconductor device may be one of the 3D-stacked semiconductor devices shown in FIGS. 4 and 5.

Referring to FIG. 8, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM module 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

The electronic device 1000 may further include at least one sensor such as an image sensor.

At least one component in the electronic device 1000 may be formed based on a semiconductor device of a forksheet transistor structure in which one or more active contacts are formed along one or more side surfaces of an isolation wall, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} source/drain pattern;
a 1^{st} active contact on the 1^{st} source/drain pattern; and
an isolation wall contacting the 1^{st} active contact.

2. The semiconductor device of claim 1, wherein the 1^{st} active contact contacts a side surface of the isolation wall.

3. The semiconductor device of claim 1 or 2, wherein the 1^{st} source/drain pattern contacts the isolation wall.

4. The semiconductor device of claim 3, further comprising a 1^{st} channel structure on the 1^{st} source/drain pattern,
wherein the 1^{st} channel structure contacts the isolation wall.

5. The semiconductor device of claim 1, further comprising:
a 2^{nd} source/drain pattern;
a 2^{nd} active contact on the 2^{nd} source/drain pattern,
wherein the isolation wall is between the 1^{st} source/drain pattern and the 2^{nd} source/drain pattern,
wherein the 1^{st} active contact contacts a 1^{st} side surface of the isolation wall, and
wherein the 2^{nd} active contact contacts a 2^{nd} side surface of the isolation wall, opposite to the 1^{st} sidewall.

6. The semiconductor device of claim 5, wherein the 1^{st} active contact and the 2^{nd} active contact are connected over a top surface of the isolation wall.

7. The semiconductor device of claim 5 or 6, further comprising:
a 1^{st} channel structure on the 1^{st} source/drain pattern; and
a 2^{nd} channel structure on the 2^{nd} source/drain pattern,
wherein the 1^{st} channel structure contacts the 1^{st} side surface of the isolation wall, and the 2^{nd} channel structure contacts the 2^{nd} side surface of the isolation wall.

8. The 3D-stacked semiconductor device of claim 7, wherein each of the 1^{st} channel structure and the 2^{nd} channel structure comprises a plurality of vertically stacked active layers.

9. The semiconductor device of claim 7 or 8, further comprising:
a 3^{rd} source/drain pattern above the 1^{st} source/drain pattern; and
a 4^{th} source/drain pattern on above the 2^{nd} source/drain pattern,
wherein the 3^{rd} source/drain pattern has a smaller width than the 1^{st} source/drain pattern, and the 4^{th} source/drain pattern has a smaller width than the 2^{nd} source/drain pattern.

10. The semiconductor device of claim 9, wherein the 1^{st} active contact is disposed between the 3^{rd} source/drain pattern and the isolation wall, and the 2^{nd} active contact is disposed between the 4^{th} source/drain pattern and the isolation wall.

11. The semiconductor device of claim 9 or 10, wherein the 1^{st} active contact contacts a top surface of the 1^{st} source/drain pattern which is not vertically overlapped by the 3^{rd} source/drain pattern.

12. The semiconductor device of claim 11, wherein the 2^{nd} active contact contacts a top surface of the 2^{nd} source/drain pattern which is not vertically overlapped by the 4^{th} source/drain pattern.

13. The semiconductor device of any one of claims 9 to 12, further comprising:
a 3^{rd} channel structure on the 3^{rd} source/drain pattern; and
a 4^{th} channel structure on the 4^{th} source/drain pattern,
wherein the 3^{rd} channel structure has a smaller width than the 1^{st} channel structure, and the 4^{th} channel structure has a smaller width than the 2^{nd} channel structure.

14. The semiconductor device of claim 13, wherein a side surface of the 3^{rd} channel structure is vertically aligned with a side surface of the 1^{st} channel structure, and a side surface of the 4^{th} channel structure is vertically aligned with a side surface of the 2^{nd} channel structure.

15. A method of manufacturing a semiconductor device, the method comprising:
forming a channel structure on a substrate;
forming a recess penetrating through the channel structure to divide the channel structure into a 1^{st} channel structure and a 2^{nd} channel structure;
forming an isolation wall in the recess;
forming a 1^{st} source/drain pattern on the 1^{st} channel structure; and
forming a 1^{st} active contact contacting the isolation wall and the 1^{st} source/drain pattern.
